# EUROPÄISCHE PATENTANMELDUNG

(11) **EP 3 333 907 A1**
(43) Veröffentlichungstag der Anmeldung: **13.06.2018**
(21) Anmeldenummer: 18151689.9
(22) Anmeldetag: 18.02.2009
(51) Int. Cl.: H01L 33/00, H01L 33/62, H01L 33/48

(54) **OPTOELEKTRONISCHES HALBLEITERBAUTEIL, GERÄT ZUR AUFZEICHNUNG VON BILDINFORMATION UND VERFAHREN ZUR HERSTELLUNG EINES OPTOELEKTRONISCHEN HALBLEITERBAUTEILS**

(30) Priorität: 07.03.2008 DE 102008013028
(62) Teilanmeldung aus: 09716250.7
(71) Anmelder: Osram Opto Semiconductors Gmbh, 93055 Regensburg (DE)
(72) Erfinder: Engl, Moritz, 93055 Regensburg (DE)
(74) Vertreter: Epping - Hermann - Fischer

(57) **Zusammenfassung**

In mindestens einer Ausführungsform des optoelektronischen Halbleiterbauteils umfasst dieses mindestens einen Anschlussträger, mindestens einen optoelektronischen Halbleiterchip, der an einer Vorderseite des Anschlussträgers angebracht ist, und mindestens zwei Federn zur elektrischen Kontaktierung des Halbleiterbauteils. Die Federn sind hierbei an einer der Vorderseite gegenüberliegenden Rückseite des Anschlussträgers aufgebracht, die Federkräfte der Federn weisen eine Komponente senkrecht zur Rückseite des Anschlussträgers auf. Ein solches optoelektronisches Halbleiterbauteil ist einfach herzustellen und lässt sich auf besonders einfache Art und Weise elektrisch mit einem externen Gerät kontaktieren.

## Beschreibung

Es wird ein optoelektronischen Halbleiterbauteil angegeben. Darüber hinaus wird ein Gerät zur Aufzeichnung von Bildinformation mit einem solchen optoelektronischen Halbleiterbauteil sowie ein Verfahren zur Herstellung eines solchen optoelektronischen Halbleiterbauteils angegeben.

Optoelektronische Bauteile, wie beispielsweise Leucht- oder Fotodioden, haben eine breite technische Anwendung und Einzug in den Alltag gefunden. Einige Gesichtspunkte, die der Verbreitung solcher Bauteile Vorschub leisteten, sind deren hohe Effizienz, Widerstandsfähigkeit gegen äußere Umwelteinflüsse, wie etwa mechanische Belastungen oder Feuchtigkeit und Wärme, hohe Lebensdauer, kompakte Bauweise und vielfältige Ausgestaltungsmöglichkeiten, und dies bei vergleichsweise geringen Fertigungskosten. Für viele dieser Eigenschaften ist die Hausung des optoelektronischen Bauteils sowie dessen elektrische Kontaktierung bedeutsam.

Eine zu lösende Aufgabe besteht darin, ein optoelektronisches Halbleiterbauteil anzugeben, das besonders gut elektrisch zu kontaktieren ist. Eine weitere zu lösende Aufgabe besteht darin, ein Gerät zur Aufzeichnung von Bildinformation anzugeben, mit dem das optoelektronische Halbleiterbauelement gut zu kontaktieren ist. Eine weitere zu lösende Aufgabe besteht darin, ein besonders effektives Verfahren zur Herstellung eines optoelektronischen Halbleiterbauelements anzugeben.

Gemäß zumindest einer Ausführungsform des optoelektronischen Halbleiterbauteils umfasst dieses mindestens einen Anschlussträger. Der Anschlussträger kann beispielsweise als Leiterrahmen oder als Leiterplatte ausgestaltet sein. Bevorzugt ist der Anschlussträger elektrisch leitfähig oder weist elektrisch leitfähige Strukturen wie Leiterbahnen auf. Ebenso bevorzugt weist der Anschlussträger eine hohe thermische Leitfähigkeit auf, insbesondere mehr als 20 W/(mK), besonders bevorzugt mehr als 50 W/(mK), ganz besonders bevorzugt mehr als 100 W/(mK). Auch weist der Anschlussträger bevorzugt eine hohe Wärmekapazität, insbesondere mehr als 0,3 kJ/(kgK), auf. Besonders geeignete Materialien zur Verwendung als Anschlussträger sind Metalllegierungen oder Metalle, wie beispielsweise Kupfer. Ebenso möglich ist die Verwendung von Keramiken, wie etwa Aluminiumoxid oder Aluminiumnitrid, oder auch von Kunststoffen, insbesondere von elektrisch leitfähigen Kunststoffen. Der Anschlussträger kann homogen beziehungsweise massiv aus einem einzigen Material bestehen oder als Materialverbund aufgebaut sein. Die Dicke des Anschlussträgers liegt insbesondere im Bereich zwischen 30 µm und 700 µm, besonders bevorzugt zwischen 150 µm und 400 µm. Der Anschlussträger ist bevorzugt flach ausgestaltet und verfügt über im Wesentlichen ebene, einander gegenüberliegende Vorder- und Rückseiten. Alternativ kann der Anschlussträger auch über Strukturierungen, zum Beispiel an der Vorderseite, verfügen, die muldenartig ausgeformt sein können und eine Einbettung etwa eines Halbleiterchips in diese Mulden vereinfachen.

Gemäß zumindest einer Ausführungsform des optoelektronischen Halbleiterbauteils umfasst dieses mindestens einen optoelektronischen Halbleiterchip. Der Halbleiterchip kann auf Materialien, wie Galliumnitrid, Galliumphosphid, Aluminiumgalliumarsenid, Galliumarsenid oder Indiumphosphid basieren. Der Halbleiterchip kann beispielsweise als Leuchtdiode, Laserdiode oder Fotodiode ausgestaltet sein. An die geometrischen Abmessungen des Halbleiterchips sind keine speziellen Anforderungen gestellt, bevorzugt beträgt die Dicke des Halbleiterchips jedoch weniger als 200 µm, besonders bevorzugt weniger als 100 µm. Insbesondere kann der Halbleiterchip beispielsweise wie in der Druckschrift WO 2005/081319 A1 beschrieben ausgeformt sein, deren Offenbarungsgehalt hinsichtlich des dort beschriebenen Halbleiterchips sowie des dort beschriebenen Herstellungsverfahrens hiermit durch Rückbezug mit aufgenommen wird. Bevorzugt steht der Halbleiterchip in direktem Kontakt zu mindestens einem Anschlussträger, das heißt, bis auf ein Verbindungsmittel wie ein Lot oder ein Kleber befindet sich keine weitere Komponente zwischen Halbleiterchip und Anschlussträger.

Kontaktierungsflächen des Halbleiterchips können sich, wie etwa bei einem Flip-Chip, auf einer Montageseite des Halbleiterchips befinden. Ebenso können sich die elektrischen Kontaktierungen an den Flanken beziehungsweise Seitenflächen des Halbleiterchips oder auf zwei einander gegenüberliegenden Seiten, beispielsweise an der Montageseite und einer Lichtdurchtrittsfläche, befinden. Dem Halbleiterchip können Lumineszenz- oder Konversionsmittel in Abstrahlrichtung nachgeordnet sein, so dass im Betrieb weißes Mischlicht emittiert wird.

Gemäß zumindest einer Ausführungsform des optoelektronischen Halbleiterbauteils umfasst dieses mindestens zwei Federn zur elektrischen Kontaktierung des Halbleiterbauteils mit einem externen Gerät. Die Federn sind an der der Vorderseite gegenüberliegenden Rückseite eines Anschlussträgers angebracht und überragen diese bevorzugt lateral nicht. Das heißt, der laterale Platzbedarf in Richtungen längs oder parallel zur Rückseite ist von den Abmessungen des Anschlussträgers bestimmt. Hierdurch kann ein besonders Platz sparendes Bauteil realisiert werden.

Die Federkräfte der Federn weisen eine Komponente senkrecht zur Rückseite des Anschlussträgers auf. Bevorzugt ist die Federkraftkomponente senkrecht zur Rückseite größer als die Komponente parallel dazu, besonders bevorzugt sind die Federkräfte in eine Richtung senkrecht zu der die Rückseite des Anschlussträgers bildenden Fläche ausgerichtet. Als Federn können beispielsweise Federstifte, so genannte Pogo-Pins, oder C-Federn verwendet werden.

Die Federn sind elektrisch leitend mit dem Anschlussträger oder mit Leiterstrukturen auf dem Anschlussträger verbunden, bevorzugt direkt ohne die Verwendung von etwa Zwischenstücken. Die Verbindung zwischen Anschlussträger und Federn kann beispielsweise mittels Löten, leitfähigem Kleben oder Pressen erfolgen. Es ist auch möglich, dass die Federn vollständig oder teilweise einstückig mit dem Anschlussträger gefertigt sind. Das Anbringen der Federn an der Rückseite des Anschlussträgers schließt nicht aus, dass ein Teil der Federn durch den Anschlussträger, insbesondere elektrisch leitfähig, von der Rückseite zur Vorderseite hindurchgeführt ist.

In mindestens einer Ausführungsform des optoelektronischen Halbleiterbauteils umfasst dieses mindestens einen Anschlussträger, mindestens einen optoelektronischen Halbleiterchip, der an einer Vorderseite des Anschlussträgers angebracht ist, und mindestens zwei Federn zur elektrischen Kontaktierung des Halbleiterbauteils. Die Federn sind hierbei an einer der Vorderseite gegenüberliegenden Rückseite des Anschlussträgers aufgebracht, die Federkräfte der Federn weisen eine Komponente senkrecht zur Rückseite des Anschlussträgers auf. Ein solches optoelektronisches Halbleiterbauteil ist einfach herzustellen und lässt sich auf besonders effektive Art und Weise elektrisch mit einem externen Gerät kontaktieren.

Gemäß zumindest einer Ausführungsform des optoelektronischen Halbleiterbauteils weist dieses zumindest stellenweise an der Vorderseite des Anschlussträgers mindestens eine erste Metallisierungsschicht und an der Rückseite des Anschlussträgers mindestens eine zweite Metallisierungsschicht auf. Bevorzugt bedeckt die zweite Metallisierungsschicht die Rückseite des Anschlussträgers zu mehr als 80 %, besonders bevorzugt vollständig. Je nach Erfordernissen können die Metallisierungsschichten Strukturen, wie beispielsweise elektrische Leiterbahnen, aufweisen. Durch die Verwendung von Metallisierungsschichten können vielfältige Materialien für den Anschlussträger eingesetzt werden, da die Eigenschaften der Oberflächen des Anschlussträgers über die Metallisierungsschichten gezielt beeinflusst werden können.

Gemäß zumindest einer Ausführungsform des optoelektronischen Halbleiterbauteils ist die Dicke der ersten Metallisierungsschicht um mindestens einen Faktor 2 größer als die Dicke der zweiten Metallisierungsschicht. Bevorzugt übersteigt die Dicke der ersten Metallisierungsschicht die der zweiten um einen Faktor größer als 4, besonders bevorzugt um einen Faktor größer als 5. Die erste und die zweite Metallisierungsschicht können beispielsweise über die Stirnseiten des Anschlussträgers miteinander in Verbindung stehen. Über die unterschiedlichen Dicken der Metallisierungsschichten können die Eigenschaften der ersten beziehungsweise der zweiten Metallisierungsschicht an der Vorder- beziehungsweise der Rückseite des Anschlussträgers gezielt beeinflusst werden. Als Eigenschaften seien hierbei insbesondere die Härte der Oberfläche und deren Lötbarkeit genannt.

Gemäß zumindest einer Ausführungsform des optoelektronischen Halbleiterbauteils sind die erste und die zweite Metallisierungsschicht jeweils Galvanisierungsschichten. Galvanisierungsschichten lassen sich effektiv auf insbesondere elektrisch leitfähigen Anschlussträgern aufbringen.

Gemäß zumindest einer Ausführungsform des optoelektronischen Halbleiterbauteils weisen dessen erste und zweite Metallisierungsschicht mindestens einen der Stoffe Kupfer, Nickel, Palladium oder Gold auf. Diese Materialien können über beispielsweise Galvanisierungstechniken effektiv auf dem Anschlussträger abgeschieden werden. Diese Materialien weisen außerdem eine gute Haftung zueinander auf und bieten eine Vielzahl an Möglichkeiten, die physikalischen Eigenschaften der Metallisierungsschicht gezielt einzustellen. Insbesondere können erste und zweite Metallisierungsschicht identische Materialfolgen aufweisen und sich lediglich in den jeweiligen Dicken der die Metallisierungsschichten bildenden, verschiedenen Metalllagen unterscheiden.

Gemäß zumindest einer Ausführungsform des optoelektronischen Halbleiterbauteils weisen die erste und die zweite Metallisierungsschicht, jeweils vom Anschlussträger aus gesehen, eine Schichtenfolge aus Nickel, Palladium und Gold auf. Die Schichtdicke des Nickels beträgt bevorzugt zwischen 0,1 und 30 µm, besonders bevorzugt zwischen 0,5 und 9 µm. Die Palladiumschicht weist eine Dicke bevorzugt zwischen 0,01 und 10 µm, besonders bevorzugt zwischen 0,05 und 0,2 µm auf. Die Dicke der Goldschicht beträgt bevorzugt zwischen 0,01 und 10 µm, besonders bevorzugt zwischen 0,05 und 2 µm. Die genannten Schichtdicken beziehen sich insbesondere auf die Rückseite des Anschlussträgers, also auf die zweite Metallisierungsschicht. Die einzelnen Schichtdicken der ersten Metallisierungsschicht sind bevorzugt entsprechend um einen Faktor 2, besonders bevorzugt um einen Faktor 4, ganz besonders bevorzugt um einen Faktor 5 größer als die für die erste Metallisierungsschicht genannten Schichtdicken.

Neben den angegebenen Materialien können auch weitere Materialien verwendet werden, um die Eigenschaften der Metallisierungsschichten je nach den konkreten Anforderungen anzupassen. Neben den verwendeten Materialien gilt dies ebenso für die gewählten Schichtdicken. Eigenschaften, die über die Zusammensetzung der Metallisierungsschichten bestimmt werden können, sind etwa elektrische Leitfähigkeit, Wärmeleitfähigkeit, Härte, Reflektivität, chemische Beständigkeit oder Adhäsionsverhalten zu Klebstoffen und Vergussmitteln.

Gemäß zumindest einer Ausführungsform des optoelektronischen Halbleiterbauteils weisen die Metallisierungsschichten, neben Nickel, Palladium und Gold, keine weiteren Bestandteile beziehungsweise Schichten auf. Bevorzugt ist die Schichtfolge, vom Anschlussträger aus gesehen, Nickel-Palladium-Gold.

Gemäß zumindest einer Ausführungsform des optoelektronischen Halbleiterbauteils sind die Federn als Federstifte ausgestaltet. Federstifte, auch als Pogo-Pins bezeichnet, weisen große Federwege auf und benötigen nur eine relativ geringe Fläche auf dem Anschlussträger, um an diesem befestigt zu werden.

Gemäß zumindest einer Ausführungsform des optoelektronischen Halbleiterbauteils umfasst dieses einen Gehäusekörper, so dass zwischen Gehäusekörper und Anschlussträger ein Hohlraum gebildet wird, in dem sich der Halbleiterchip befindet. Der Gehäusekörper ist bevorzugt für die vom Halbleiterchip in dessen Betrieb zu emittierende oder zu empfangende Strahlung zumindest teilweise durchlässig. Der Gehäusekörper kann als optisch wirksames Element, wie beispielsweise als Linse, Fresnel-Linse, Lichtleiter, Reflektor oder Filter, ausgestaltet sein. Dem Gehäusekörper können Stoffe beigemengt, beigegeben oder aufgetragen sein, etwa in Form von Konversionsmitteln, Filtermitteln, Diffusormitteln oder photonischen Kristallen. Der Gehäusekörper kann beispielsweise wie in der Druckschrift DE 102004045947 A1 ausgestaltet sein, deren Offenbarungsgehalt bezüglich des Gehäusekörpers hiermit durch Rückbezug mit aufgenommen wird. Der Gehäusekörper kann in lateraler Richtung bündig mit dem Anschlussträger abschließen oder diesen lateral überragen. Über die Ausgestaltung des Gehäusekörpers können die optischen Eigenschaften des optoelektronischen Halbleiterbauteils vielfältig ausgestaltet und leicht variiert werden.

Gemäß zumindest einer Ausführungsform des optoelektronischen Halbleiterchips weist der Anschlussträger an der Vorder- und/ oder der Rückseite zumindest stellenweise eine elektrisch isolierende Schicht auf. Die Schicht auf der Vorderseite bedeckt diese bevorzugt zu mindestens 50 %, besonders bevorzugt zu mindestens 75 %. Die Rückseite ist von der Schicht bevorzugt zu weniger als 25 %, besonders bevorzugt zu weniger als 10 % bedeckt.

Gemäß zumindest einer Ausführungsform des optoelektronischen Halbleiterbauteils umfasst dieses mindestens zwei Anschlussträger, die zumindest stellenweise an deren Vorderseiten eine elektrisch isolierende Schicht aufweisen. Insbesondere, wenn elektrisch leitfähige Materialien für die Anschlussträger verwendet werden, kann über eine isolierende Schicht etwa die Vorderseite der Anschlussträger strukturiert werden, so dass Chipanschlussbereiche oder Leiterbahnen resultieren. Die Verwendung zweier verschiedener Anschlussträger ermöglicht es, dass zum Beispiel Anode und Kathode des Halbleiterchips je mit verschiedenen, nicht elektrisch verbundenen Anschlussträgern elektrisch kontaktiert werden können. Dies erleichtert einen Aufbau des optoelektronischen Bauteils und erhöht die Ausgestaltungsmöglichkeiten.

Die Dicke der elektrisch isolierenden Schicht ist bevorzugt geringer als die Dicke des Halbleiterchips. Die elektrisch isolierende Schicht beschränkt sich bevorzugt auf die Vorderseite der Anschlussträger, kann aber ebenso Teile der Rückseiten oder insbesondere auch der Stirn- beziehungsweise Seitenflächen der Anschlussträger zumindest stellenweise bedecken. Unter Stirnflächen sind jeweils diejenigen Flächen zu verstehen, die die Vorderseite mit der Rückseite des Anschlussträgers verbinden. Die Stirnseiten können senkrecht zur Vorder- und Rückseite ausgerichtet sein. Die elektrisch isolierende Schicht wird bevorzugt durch ein Harz oder ein Epoxidharz gebildet, ebenso möglich ist es, dass die elektrisch isolierende Schicht durch einen Lack, einen Kunststoff oder ein Silikon gebildet wird. Bevorzugt sind unter isolierender Schicht insbesondere keine einem Gehäusekörper ähnlichen Komponenten wie zum Beispiel Linsen zu verstehen. Die Schicht ist bevorzugt im Wesentlichen flach ausgeprägt, das heißt, die laterale Ausdehnung der gesamten Schicht ist deutlich größer als deren vertikale Ausdehnung. Bevorzugt ist pro Anschlussträger genau eine Feder vorgesehen, die an der jeweiligen Rückseite des Anschlussträgers angebracht ist.

Gemäß zumindest einer Ausführungsform des optoelektronischen Halbleiterbauteils, bei dem dieses mindestens zwei Anschlussträger umfasst, verbindet die elektrisch isolierende Schicht die Anschlussträger mechanisch miteinander. Hierdurch können die Anschlussträger beispielsweise derart arrangiert werden, dass sie eine günstige Plattform für die Montage des Halbleiterchips bilden. Die mindestens zwei Anschlussträger können beispielsweise mit einem Harz über Gießen verbunden werden. Ebenfalls möglich ist es, dass die Anschlussträger etwa über eine klebende Verbindung über einen elektrisch isolierenden Träger, beispielsweise in Form ähnlich eines Kunststoffrahmens, mechanisch miteinander verbunden werden. Die isolierende Schicht muss nicht mechanisch starr sein, sie kann folienähnliche Flexibilität aufweisen. Die Biegestabilität kann dann dadurch erzielt werden, dass etwa U-förmige, ineinander greifende Anschlussträgergeometrien Verwendung finden.

Es wird weiterhin ein Gerät zur Aufzeichnung von Bildinformation angegeben. Gemäß zumindest einer Ausführungsform dieses Geräts weist dieses mindestens ein optoelektronisches Halbleiterbauteil gemäß einer der diesbezüglich beschriebenen Ausführungsformen auf. Zur Aufnahme des Halbleiterbauteils umfasst das Gerät bevorzugt mindestens eine Öffnung. Das Halbleiterbauteil kann in dieser Öffnung eingebracht werden, bevorzugt passgenau. Über die Federn kann das Halbleiterbauteil mit etwa Kontaktierungsflächen des Geräts elektrisch verbunden sein. Über die Verwendung von Federn im Zusammenhang mit dem Gerät können Fertigungs- und Positioniertoleranzen, wie sie beispielsweise beim Löten zu beachten sind, aufgeweitet werden. Auch kann das optoelektronische Halbleiterbauteil reversibel in dem Gerät angebracht sein, so dass es bevorzugt ohne Werkzeugeinsatz ersetzt werden kann. Neben der elektrischen Kontaktierung mit dem Gerät kann über die Federn das Halbleiterbauteil auch mechanisch an diesem gehaltert werden. Außer den Federn sind bevorzugt keine weiteren Verbindungsmittel zur elektrischen und/oder mechanischen Verbindung von Gerät und Halbleiterbauteil erforderlich. Die konkrete Ausgestaltung von Gerät, Öffnung zur Aufnahme des Halbleiterbauteils und Halbleiterbauteil selbst richtet sich nach den jeweiligen konkreten Erfordernissen.

Mögliche Geräte, in denen ein beschriebenes Halbleiterbauteil Verwendung finden kann, sind zum Beispiel Fotoapparate, Videokameras oder Handys. Neben diesen ist auch jedes weitere Gerät in diesem Kontext heranziehbar, das zur Aufzeichnung von Bildinformation bestimmt ist. Es kommt hierbei nicht darauf an, ob die Bildinformation nur temporär oder dauerhaft, analog auf beispielsweise Filmen oder Magnetbändern oder auf einem digitalen Speichermedium festgehalten wird. Das optoelektronische Halbleiterbauteil ist im Zusammenhang mit einem solchen Gerät bevorzugt als Blitzlicht oder leuchtstarke Lampe ausgestaltet. Der Halbleiterchip 2 ist in diesem Falle bevorzugt als Weißlichtquelle konzipiert, die eine homogene spektrale Signatur über den gesamten sichtbaren Spektralbereich aufweist. Das Halbleiterbauteil ist auch zum Erzeugen von Blitzlicht, das heißt, zur Erzeugung kurzer Beleuchtungsdauern von etwa 200 ms und weniger, geeignet.

Es wird darüber hinaus ein Verfahren zur Herstellung eines optoelektronischen Halbleiterbauteils angegeben. Beispielsweise kann mittels dem Verfahren ein optoelektronisches Halbleiterbauteil oder Gerät hergestellt werden, wie es in Verbindung mit einer oder mehrerer der oben genannten Ausführungsformen beschrieben ist.

Das Verfahren weist gemäß zumindest einer Ausführungsform die folgenden Verfahrensschritte auf:
- Bereitstellen mindestens eines Anschlussträgers,
- mindestens stellenweises Aufbringen einer elektrisch isolierenden Beschichtung auf dem Anschlussträger,
- Aufbringen mindestens einer ersten Metallisierungsschicht auf einer Vorderseite und einer zweiten Metallisierungsschicht auf einer Rückseite des Anschlussträgers, wobei die von der elektrisch isolierenden Schicht unbedeckten Bereiche des Anschlussträgers beschichtet werden,
- Anbringen von mindestens zwei Federn an einer Rückseite des Anschlussträgers, und
- Anbringen mindestens eines optoelektronischen Halbleiterchips an einer Vorderseite des Anschlussträgers.

Gemäß zumindest einer Ausführungsform des Verfahrens werden die Metallisierungsschichten über ein elektrogalvanisches Verfahren aufgebracht. Alternative Beschichtungsverfahren stellen etwa Aufdampfen, Sputtern, Tauchverfahren oder Lackierverfahren dar. Über elektrogalvanische Verfahren können allerdings besonders einfach auch Mehrschichtsysteme aus verschiedenen insbesondere metallischen Materialien auf dem Anschlussträger aufgebracht werden.

Gemäß zumindest einer Ausführungsform des Verfahrens wird das Verhältnis der Schichtdicken von erster Metallisierungsschicht zu zweiter Metallisierungsschicht mittels des Bedeckungsgrads der Vorderseite mit der elektrisch isolierenden Schicht bestimmt. Dies stellt insbesondere eine bevorzugte Möglichkeit dar, die Schichtdicken von erster und zweiter Metallisierungsschicht einzustellen, wenn die Metallisierungen mittels eines elektrogalvanischen Verfahrens aufgebracht werden. Bei elektrogalvanischen Verfahren richtet sich die Schichtdicke des abzuscheidenden Materials nach der Stärke des elektrischen Felds, das lokal anliegt, sowie nach der Dauer des Aufbringens. Bevorzugt werden beide Metallisierungsschichten zeitgleich im selben Galvanisierungsbad erzeugt, mit somit gleichen Beschichtungsdauern.

Sind beispielsweise Dreiviertel der Vorderseite mit einem elektrisch isolierenden Material beschichtet und ist die Rückseite unbeschichtet, so stellt die elektrisch leitende Fläche der Vorderseite nur ein Viertel der elektrisch leitenden Fläche der Rückseite dar. Über das Flächenverhältnis von 1 : 4 bildet sich ebenfalls ein Feldstärkenverhältnis von 1 : 4 und somit über das Beschichtungsverfahren auch ein Schichtdickenverhältnis von 1 : 4 aus, bei gleichen Beschichtungszeiten beider Metallisierungsschichten. Über die elektrisch isolierende Schicht können im Falle der Verwendung mehrerer Anschlussträger diese mechanisch miteinander verbunden werden. Die isolierende Schicht ist auch dazu geeignet, Chipanschlussbereiche oder Leiterbahnen auf dem Anschlussträger zu strukturieren.

Gemäß zumindest einer Ausführungsform des Verfahrens wird als oberste Schicht der Metallisierungsschichten eine Goldschicht aufgebracht und die elektrische Kontaktierung des Halbleiterchips erfolgt zu zumindest einem Anschlussträger hin über das Bonden mit mindestens einem Bonddraht. Die Kontaktierung des Halbleiterchips erfolgt also beispielsweise von einer Strahlungsdurchtrittsfläche des Halbleiterchips, die dem Anschlussträger abgewandt ist, über einen Bonddraht zur obersten Goldschicht.

Die erste Metallisierungsschicht ist in diesem Falle so zu gestalten, dass ein Anbonden erfolgen kann, insbesondere muss die erste Metallisierungsschicht relativ weich ausgeprägt sein. Dies kann durch eine vergleichsweise dicke oberste Goldlage realisiert werden. Da an der Rückseite des Anschlussträgers Federn anzubringen sind, ist die zweite Metallisierungsschicht insbesondere hart auszugestalten. Durch eine vergleichsweise dünne oberste Goldlage ist dies gewährleistbar. Dieses Einstellen unterschiedlicher Eigenschaften der Metallisierungsschichten kann dadurch bewerkstelligt werden, dass, wie bereits beschrieben, geeignete Schichtfolgen in geeigneten Schichtdicken auf Vorder- beziehungsweise Rückseite des Anschlussträgers abgeschieden werden.

Mit diesem Verfahren können also mittels eines elektrogalvanischen Verfahrens zeitgleich Metallisierungsschichten an Vorder- und Rückseite eines Anschlussträgers gleicher Zusammensetzung, aber unterschiedlicher Dicken und somit mit unterschiedlichen Eigenschaften erzeugt werden. Das Dickenverhältnis der Metallisierungsschichten kann ohne großen Aufwand über den Beschichtungsgrad mit einem isolierenden Material eingestellt werden.

Nachfolgend wird die Erfindung unter Bezugnahme auf die Zeichnung anhand von Ausführungsbeispielen beschrieben. Gleiche Bezugszeichen geben dabei gleiche Elemente in den einzelnen Figuren an. Es sind dabei jedoch keine maßstäblichen Bezüge dargestellt.

Es zeigen:
Figur 1 eine schematische dreidimensionale Darstellung (a) sowie eine schematische Schnittdarstellung (b) eines Ausführungsbeispiels eines optoelektronischen Halbleiterbauteils,
Figur 2 eine schematische dreidimensionale Darstellung (a) eines Ausführungsbeispiels eines Halbleiterbauteils mit Linse, sowie eine schematische Schnittdarstellung (b),
Figur 3 eine schematische dreidimensionale Vorderseitenansicht (a), eine schematische Unterseitenansicht (b) eines weiteren Ausführungsbeispiels eines Halbleiterbauteils mit einem Vergusskörper, sowie eine dreidimensionale Darstellung mit aufgesetzter Linse (c),
Figur 4 eine schematische Draufsicht (a) sowie eine schematische Schnittdarstellung (b) eines Ausführungsbeispiels eines Halbleiterbauteils mit C-Feder,
Figur 5 eine schematische Schnittdarstellung (a) sowie eine schematische Draufsicht (b) eines weiteren Ausführungsbeispiels eines Halbleiterbauteils,
Figur 6 eine schematische Schnittdarstellung (a) sowie eine schematische Draufsicht (b) eines Ausführungsbeispiels mit mehreren Halbleiterchips,
Figur 7 ein Ausführungsbeispiel eines Geräts mit einem Halbleiterbauteil, das über Federn elektrisch (a) sowie elektrisch und mechanisch (b) mit dem Gerät verbunden ist, und
Figur 8a - 8e eine schematische Darstellung eines Verfahrens zur Herstellung eines optoelektronischen Halbleiterbauteils.

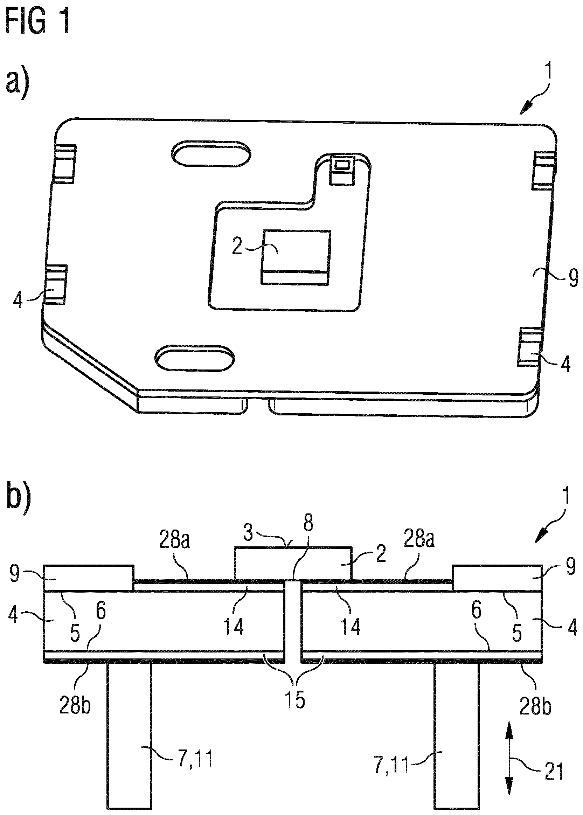

In Figur 1 ist ein Ausführungsbeispiel eines optoelektronischen Halbleiterbauteils 1 gezeigt. Das Halbleiterbauteil 1 umfasst zwei elektrisch nicht leitend verbundene Anschlussträger 4, die jeweils aus Kupfer bestehen und eine Dicke von zirka 210 µm aufweisen. Vorderseiten 5 der Anschlussträger 4 sind jeweils zu etwa 4/5 mit einer elektrisch isolierenden Schicht 9 aus einem Epoxidharz beschichtet, so dass Chipmontagebereiche und Leiterbahnen ähnliche Strukturen ausgebildet sind. Die Dicke dieser Schicht beträgt zirka 200 µm. An den Stellen, die von der elektrisch isolierenden Schicht 9 unbedeckt sind, ist eine erste Metallisierungsschicht 14 aufgebracht. Vom Anschlussträger 4 aus gesehen besteht die erste Metallisierungsschicht jeweils aus zirka 25 µm Nickel, zirka 2,5 µm Palladium und zirka 5 µm Gold. Die oberste Schicht 28a ist also eine Goldschicht. Eine zweite Metallisierungsschicht 15 auf Rückseiten 6 der Anschlussträger 4 weist eine entsprechende Schichtenfolge auf, mit einer obersten Schicht 28b, wobei die einzelnen Schichtdicken jeweils um einen Faktor 5 weniger dick sind, entsprechend dem Flächenverhältnis der unbeschichteten Bereiche von Vorder- und Rückseiten. Die lateralen Abmessungen des Halbleiterbauteils 1 betragen in diesem Ausführungsbeispiel zirka 4 x 5 mm².

An den Rückseiten 6 der Anschlussträger 4 sind Federstifte 11 angebracht, beispielsweise mittels Löten. Die Federstifte 11 haben einen Durchmesser von zirka 0,5 mm an deren Spitze, das heißt an dem Ende, das den Anschlussträgern 4 abgewandt ist, einen Durchmesser von zirka 2 mm an den mit den Anschlussträgern 4 verbundenen Enden, und eine Länge von zirka 4,5 mm bei einem Federweg von etwa 0,5 mm. Die Richtung 21 der Federkraft ist im Wesentlichen senkrecht zu den Rückseiten 6 orientiert.

Die zwei Anschlussträger 4 sind über die elektrisch isolierende Schicht 9 mechanisch miteinander verbunden. Die Anschlussträger 4 sind so beabstandet beziehungsweise angeordnet, dass ein optoelektronischer Halbleiterchip, der beispielsweise dazu ausgestaltet ist, weißes sichtbares Licht an einer Strahlungsdurchtrittsfläche 3 zu emittieren, auf den Anschlussträgern 4 so platziert ist, dass Anode beziehungsweise Kathode, die sich beide auf einer den Anschlussträgern 4 zugewandten Montageseite 8 des Halbleiterchips 2 befinden, auf verschiedenen Anschlussträgern 4 liegen. Anode und Kathode des Halbleiterchips 2 sind an die Anschlussträger 4 angelötet.

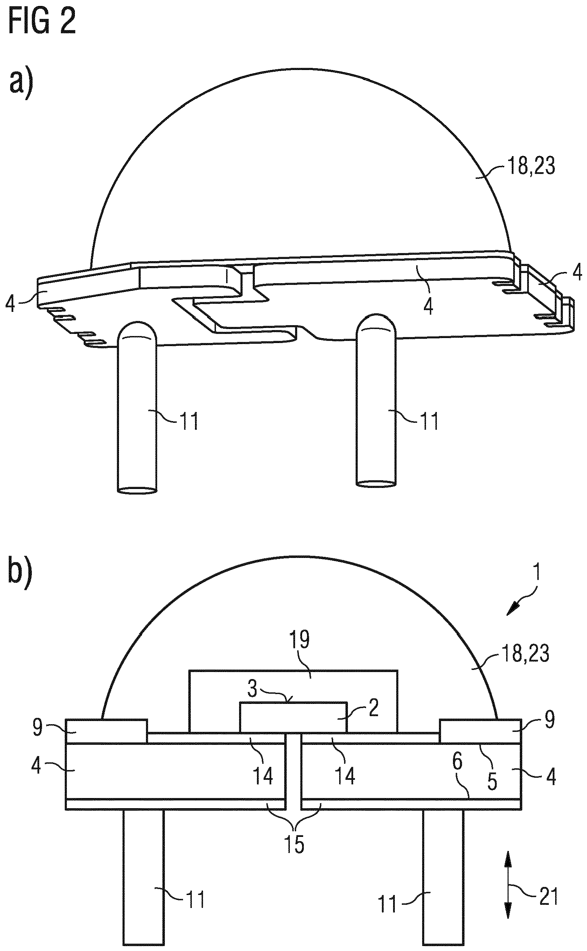

In Figur 2 ist ein weiteres Ausführungsbeispiel dargestellt. Anschlussträger 4, Federn 7, Metallisierungsschichten 14, 15, elektrisch isolierende Schicht 9 und Halbleiterchip 2 entsprechen im Wesentlichen dem Ausführungsbeispiel gemäß Figur 1. Die Anschlussträger 4 sind derart aufgeformt, dass sie ineinander greifen, ohne sich gegenseitig zu berühren, so dass keine elektrisch leitende Verbindung zwischen den Anschlussträger 4 entsteht. Dies kann, über Vermittlung der isolierenden Schicht 9, die Biegestabilität des Bauteils 1 erhöhen.

Zusätzlich ist ein Gehäusekörper 18 auf den Vorderseiten 5 der Anschlussträger 4 aufgebracht. Der Gehäusekörper 18 bildet ein optisches Element 23 in Form einer Linse aus. Geeignete Materialien für den Gehäusekörper 18 stellen beispielsweise Gläser, Thermoplasten, Duroplasten oder Silikone dar. Auch andere Materialien, die im Wesentlichen für die vom Halbleiterchip 2 zu empfangende oder zu emittierende Strahlung mindestens in einem Spektralbereich durchlässig sind und eine ausreichende Haftung auf den Anschlussträger 4 aufweisen, können Verwendung finden. Der Gehäusekörper 18 ist bevorzugt aus einem Material gestaltet, das die im Betrieb des Halbleiterchips 2 auftretenden thermischen und fotochemischen Belastungen standhält.
Der Gehäusekörper 18 ist in diesem Ausführungsbeispiel auf die Anschlussträger 4 aufgeklebt. Alternative Befestigungsmethoden, wie etwa direktes Umgießen, Aufpressen, Aufprägen oder Verschraubungen sind ebenso möglich. Gehäusekörper 18 und Anschlussträger 4, in diesem Falle zusätzlich die elektrisch isolierende Schicht 9, schließen einen Hohlraum 19 ein. In diesem Hohlraum 19 befindet sich der Halbleiterchip 2. Da der Halbleiterchip 2 nicht in direktem Kontakt zum Gehäusekörper 18 steht, treten zwischen diesen beiden Komponenten keine thermischen Spannungen, die aus dem Betrieb des Halbleiterchips 2 resultieren, auf.

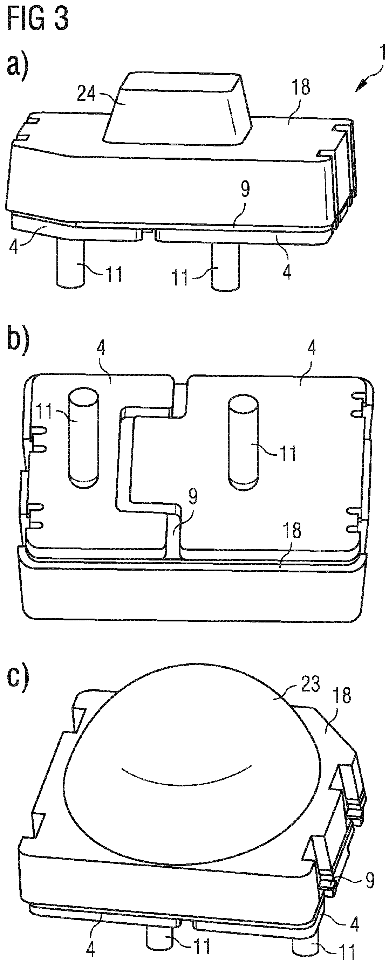

Beim Ausführungsbeispiel gemäß Figur 3 ist das Halbleiterbauteil 1 mit einem Gehäusekörper 18 versehen. Federn 7, Anschlussträger 4, isolierende Schicht 9 und Halbleiterchip 2 entsprechen im Wesentlichen den Ausführungsbeispielen gemäß Figur 1 und 2. Gemäß Figur 3a und 3b ist der Gehäusekörper 18 derart ausgestaltet, dass er dem Halbleiterchip 2 einerseits Schutz vor äußeren Einflüssen, wie mechanischer Belastung oder Feuchtigkeit bietet, und zum anderen ein leichtes Anbringen und Justieren etwa einer Linse 23 ermöglicht. Hierzu weist der Gehäusekörper 18 an der den Anschlussträgern 4 abgewandten Seite eine Auswölbung 24 auf, dessen Gegenform sich an der Linse 23 befindet. Auf diese Art und Weise ist die Linse 23, wie in Figur 3c dargestellt, auf dem Gehäusekörper 18 leicht anzubringen und präzise und einfach zu justieren.

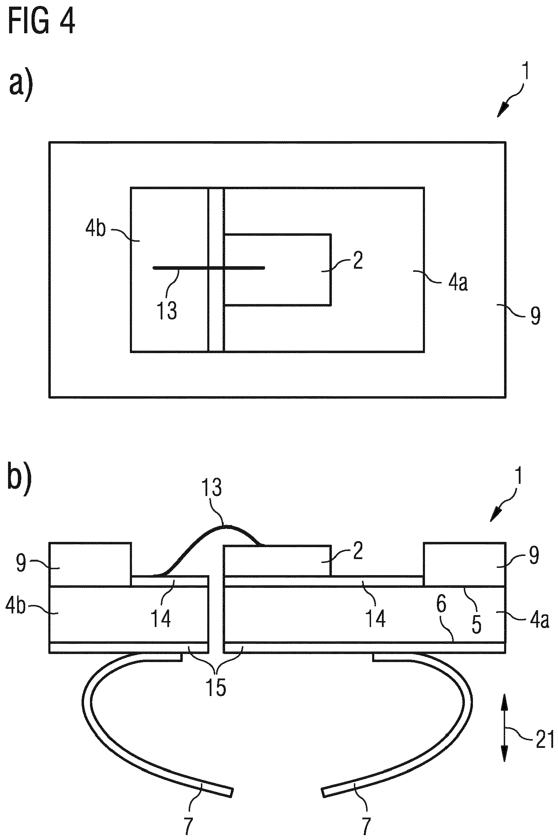

Das Halbleiterbauteil 1 im Ausführungsbeispiel gemäß Figur 4 weist zwei C-Federn 7 auf, die in direktem Kontakt zu den Rückseiten 6 der Anschlussträger 4 stehen. Die beiden in Draufsicht rechteckigen Anschlussträger 4 sind voneinander separiert, so dass keine elektrisch leitende Verbindung zwischen den Anschlussträgern 4 besteht, und mechanisch über eine balkenartig ausgeführte elektrisch isolierende Schicht 9 miteinander mechanisch verbunden. Die Anschlussträger 4 bestehen zum Beispiel massiv aus Kupfer. Der Halbleiterchip 2 steht mit der gesamten, dem Anschlussträger 4a zugewandten Montageseite 8 mit dem Anschlussträger 4a in Kontakt. Die Vorderseite 5 des Anschlussträgers 4a wirkt reflektierend für die vom Halbleiterchip 2 in dessen Betrieb zu emittierende oder zu empfangende elektromagnetische Strahlung. Mit dem Anschlussträger 4b ist der Halbleiterchip 2 über einen Bonddraht 13 elektrisch verbunden. Die erste Metallisierung 14 ist entsprechend derart ausgestaltet, dass ein Bonden beziehungsweise Löten an die erste Metallisierungsschicht 14 unproblematisch möglich ist. Die zweite Metallisierungsschicht 15 an den Rückseiten 6 der Anschlussträger 4 ist dazu geeignet, mit den Federn 7 verbunden zu werden und weist daher eine größere Härte auf.

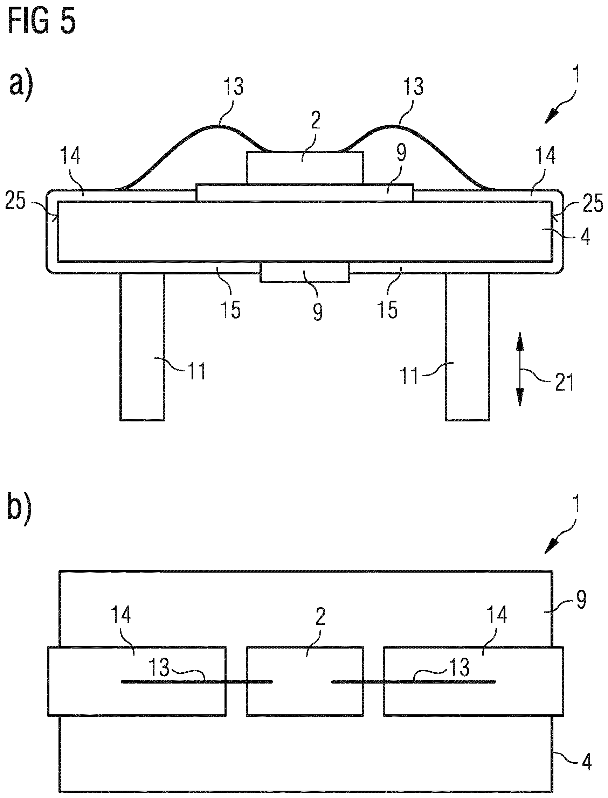

Das optoelektronische Halbleiterbauteil 1 gemäß Figur 5 weist nur einen einstückigen Anschlussträger 4 auf. Der elektrisch isolierende Anschlussträger 4 ist beispielsweise aus einer thermisch leitfähigen Keramik, etwa Aluminiumoxid, gestaltet. An der Vorderseite 5 des Anschlussträgers 4 ist ein Halbleiterchip 2 angebracht. Die elektrischen Kontaktierungen des Halbleiterchips 2 befinden sich an der dem Anschlussträger 4 abgewandten Strahlungsdurchtrittsfläche 3 des Halbleiterchips 2. Entsprechend ist der Halbleiterchip 2 über zwei Bonddrähte 13 elektrisch leitend mit Bereichen der ersten Metallisierungsschicht 14 verbunden. Über elektrisch isolierende, ebenfalls thermisch leitfähige Schichten 9 an Vorder- 5 und Rückseite 6 sind die Metallisierungsschichten 14, 15 so strukturiert, dass sie auch über die Stirnflächen 25 hinweg eine elektrische Verbindung von der Vorderseite 5 zur Rückseite 6 des Anschlussträgers 4 bewerkstelligen. An der Rückseite 6 sind zwei Federstifte 11 derart angebracht, dass jeweils ein Federstift 11 mit der Anode beziehungsweise der Kathode des Halbleiterchips 2 elektrisch verbunden ist.

Durch die Ausgestaltung des Anschlussträgers 4 aus einer Keramik sind die thermischen Ausdehnungskoeffizienten von Halbleiterchip 2 und Anschlussträger 4 ähnlich, so dass im Betrieb des Halbleiterchips 2 keine signifikanten thermischen Spannungen auftreten. Dies gilt insbesondere, wenn die isolierenden Schichten 9 ebenfalls keramisch sind.

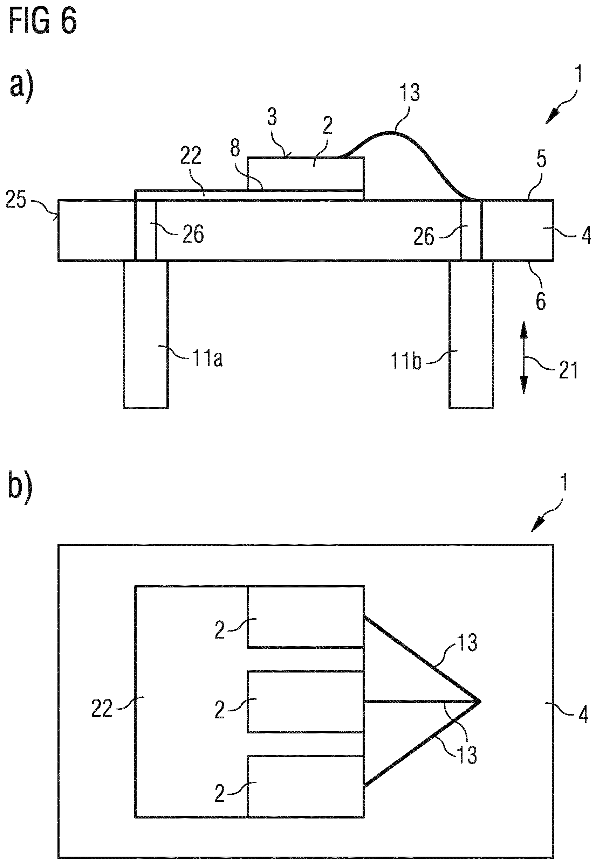

Im Ausführungsbeispiel gemäß Figur 6 sind mehrere Halbleiterchips 2 auf einem einzigen thermisch leitfähigen Anschlussträger 4 angebracht. Der Anschlussträger 4 ist entweder elektrisch isolierend oder stellenweise elektrisch isolierend beschichtet. Die an der Rückseite 6 des Anschlussträgers 4 angebrachten Federstifte 11 sind über Durchkontaktierungen 26 zur Vorderseite 5 des Anschlussträgers geführt. Die Durchkontaktierung 26 bezüglich des Federstifts 11a ist an der Vorderseite 5 elektrisch weitergeführt in Leitungen 22, die die Halbleiterchips 2 an deren Montageseiten 8 kontaktieren. Über die Strahlungsdurchtrittsflächen 3 und mittels Bonddrähten 13 sind die Halbleiterchips 2 mit dem zweiten Federstift 11b verbunden.

Es können gleichartige oder auch verschiedenartige Halbleiterchips 2 verwendet werden, so dass sich beispielsweise aus rot, grün und blau emittierenden Halbleiterchips eine Weißlichtquelle hoher Intensität ergeben kann, die zur Verwendung etwa als Blitzlicht geeignet ist. Ebenso kann die Anzahl der Halbleiterchips 2 an die jeweiligen Anforderungen angepasst sein. Alternativ können zur elektrischen Kontaktierung der Halbleiterchips 2 ausschließlich entsprechend strukturierte Leitungen 22 oder ausschließlich Bonddrähte 13 verwendet werden.

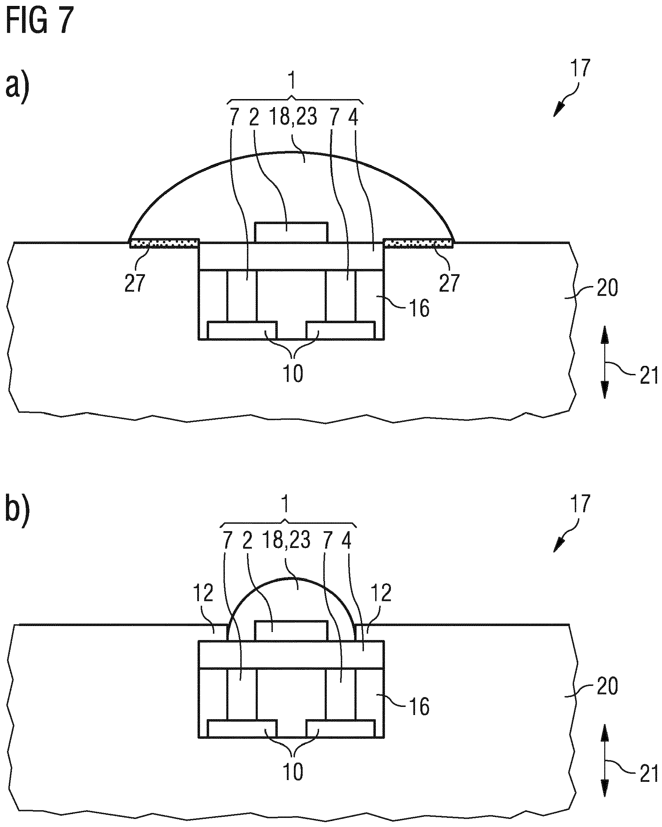

In Figur 7a ist schematisch ein Gerät etwa zur Aufzeichnung von Bildinformationen gezeigt, das ein optoelektronisches Halbleiterbauteil gemäß einem der vorhergehenden Ausführungsbeispiele umfasst. Ein Gerätekörper 20 weist eine Öffnung 16 auf, in der sich das Halbleiterbauteil 1 im Wesentlichen befindet. Das Halbleiterbauteil 1 weist eine Linse 23 auf, die lateral über einen Anschlussträger 4 hinausragt. Über diese den Anschlussträger 4 überragenden Teile ist die Linse 23 und somit das Halbleiterbauteil 1 über eine Klebverbindung 27 mit dem Gerätekörper 20 am oberen Rand der Öffnung 16 verbunden. Auf dem Grund der Öffnung 16 befinden sich zwei Kontaktflächen 10, die flächig ausgestaltet sind und zur elektrischen Kontaktierung zwischen Gerätekörper 20 und Halbleiterbauteil 1 dienen. Da das Halbleiterbauteil 1 über die Klebeverbindung 27 am Gerätekörper 20 fixiert ist, können die Federn 7, die als Federstifte 11 ausgeformt sind, einen permanenten Druck auf die Kontaktflächen 10 ausüben, wodurch der elektrische Kontakt realisiert wird. Über die Federwirkung der Federstifte 11 können Toleranzen etwa bezüglich der Dicke der Klebeverbindung 27 ausgeglichen werden. Laterale Toleranzen können durch eine flächige Ausgestaltung der Kontaktflächen 10 abgefangen werden.

Eine aufwändige genaue Positionierung, wie dies beispielsweise für Lötkontakte erforderlich ist, entfällt durch diese Anordnung.

Im Ausführungsbeispiel gemäß Figur 7b ist das Halbleiterbauteil 1 ebenfalls in einer Öffnung 16 im Gerätekörper 20 angebracht. Die Öffnung 16 weist eine Verengung bildende Vorsprünge 12 auf, die derart gestaltet sind, dass das Halbleiterbauteil über die Federwirkung der Federn 7 zwischen dieser Verengungen und dem Boden der Öffnung 16 vertikal fixiert und hierdurch mechanisch gehaltert ist. Die Kontaktflächen 10 sind analog zum Ausführungsbeispiel gemäß Figur 7a ausgestaltet.

Alternativ kann die Öffnung 16 Führungsschienen, Passungen oder Arretiervorrichtungen wie Klemmbügel aufweisen. Auch kann der Gehäusekörper 20 mehrere Öffnungen 16 umfassen. Durch Federn 7 wird es jeweils ermöglicht, Toleranzen etwa durch Fertigungsprozesse bei der Herstellung des Gehäusekörpers 20 ausgleichen zu können.

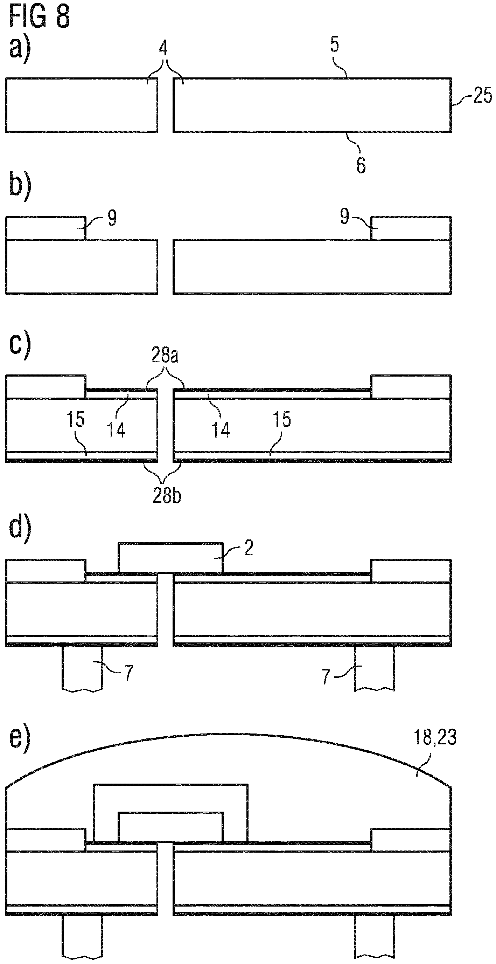

In Figur 8a bis Figur 8e sind verschiedene Schritte des Herstellungsverfahrens eines optoelektronischen Halbleiterbauteils dargestellt. Gemäß Figur 8a werden zwei massiv aus Kupfer bestehende Anschlussträger 4 bereitgestellt.

Gemäß Figur 8b erfolgt eine Beschichtung der Vorderseiten 5 der Anschlussträger 4 mit einer elektrisch isolierenden Schicht 9. Die Schicht 9 nimmt einen Großteil der Vorderseiten 5 der Anschlussträger 4 ein. Wie etwa in Figur 1 gezeigt, sind die Anschlussträger derart angeordnet, dass ein später aufzubringender Halbleiterchip 2 mit den Anschlussträgern 4 kontaktiert werden kann. Über die Schicht 9 sind die Anschlussträger 4 zueinander mechanisch fixiert, beispielsweise wie im Ausführungsbeispiel gemäß Figur 4.

In Figur 8c werden über ein elektrogalvanisches Verfahren Metallisierungsschichten aufgebracht. Da die Vorderseite 5 eine geringere elektrisch leitfähige Fläche aufweist als die Rückseiten 6, werden über den Vorderseiten 5 größere Schichtdicken aufgebracht. Die erste Metallisierungsschicht 14 auf den Vorderseiten 5 weist daher eine größere Schichtdicke einer obersten Schicht 28a aus Gold auf und ist somit relativ weich und für ein Auflöten eines Halbleiterchips 2, wie in Figur 8d dargestellt, geeignet. Die dünnere oberste Schicht 28b aus Gold der zweiten Metallisierungsschicht 15 an den Rückseiten 6 ist härter ausgeprägt und dazu geeignet, dass als Federstifte 11 ausgeformte Federn 7 an den Rückseiten 6 angebracht werden können.

In einem optionalen Verfahrensschritt gemäß Figur 8e kann abschließend ein Gehäusekörper 18, ausgestaltet etwa wie in Figur 3 gezeigt, aufgebracht werden. Alternativ zum Aufbringen eines Gehäusekörpers mit einem Hohlraum 19, der von Gehäusekörper 18 und Anschlussträger 4 und eventuell isolierender Schicht 9 gebildet wird, kann der Halbleiterchip 2 auch direkt mit einer Spritzmasse, etwa in einem Spritzgussverfahren, umgossen werden.

Die hier beschriebene Erfindung ist nicht durch die Beschreibung anhand der Ausführungsbeispiele beschränkt. Vielmehr umfasst die Erfindung jedes neue Merkmal sowie die Kombination von Merkmalen, was insbesondere jede Kombination von Merkmalen in den Patentansprüchen beinhaltet. Auch wenn das Merkmal oder diese Kombination selbst nicht explizit in den Patentansprüchen oder Ausführungsbeispielen angegeben ist.

Diese Patentanmeldung beansprucht die Priorität der deutschen Patentanmeldung 10 2008 013 028.1, deren Offenbarungsgehalt hiermit durch Rückbezug aufgenommen wird.

## Patentansprüche

1. Optoelektronisches Halbleiterbauteil (1) mit
- mindestens einem Anschlussträger (4),
- mindestens einem optoelektronischen Halbleiterchip (2), der an einer Vorderseite (5) des Anschlussträgers (4) angebracht ist, und
- mindestens zwei Federn (7) zur elektrischen Kontaktierung des Halbleiterbauteils (1),
wobei die Federn (7) an einer der Vorderseite (5) gegenüberliegenden Rückseite (6) des Anschlussträgers (4) angebracht sind, und wobei Federkräfte der Federn (7) eine Komponente senkrecht zur Rückseite (6) aufweisen, und
- zumindest stellenweise an der Vorderseite (5) des Anschlussträgers (4) mindestens eine erste Metallisierungsschicht (14) und an der Rückseite (6) mindestens eine zweite Metallisierungsschicht (15) aufgebracht ist,
**dadurch gekennzeichnet, dass**
die erste Metallisierungsschicht (14) eine mindestens um einen Faktor 2 größere Dicke aufweist als die zweite Metallisierungsschicht (15) und ein Dickenverhältnis der Metallisierungsschichten (14, 15) über den Beschichtungsgrad des Anschlussträgers (4) mit einer elektrisch isolierenden Schicht (9) eingestellt ist.

2. Optoelektronisches Halbleiterbauteil (1) nach dem vorhergehenden Anspruch,
bei dem die erste und die zweite Metallisierungsschicht (14, 15) identische Materialfolgen aufweisen und sich lediglich in den jeweiligen Dicken von die Metallisierungsschichten (14, 15) bildenden, verschiedenen Metalllagen unterscheiden.

3. Optoelektronisches Halbleiterbauteil (1) nach einem der vorhergehenden Ansprüche,
bei dem die Dicke der ersten Metallisierungsschicht (14) mindestens um einen Faktor 5 größer ist als die Dicke der zweiten Metallisierungsschicht (15).

4. Optoelektronisches Halbleiterbauteil (1) nach einem der vorhergehenden Ansprüche,
bei dem die erste und zweite Metallisierungsschicht (14, 15) jeweils Galvanisierungsschichten sind.

5. Optoelektronisches Halbleiterbauteil (1) nach einem der vorhergehenden Ansprüche,
dessen erste und zweite Metallisierungsschicht (14, 15) mindestens einen der Stoffe Kupfer, Nickel, Palladium oder Gold enthalten.

6. Optoelektronisches Halbleiterbauteil nach einem der vorhergehenden Ansprüche,
bei dem die erste und die zweite Metallisierungsschicht (14, 15), vom Anschlussträger (4) aus gesehen, eine Schichtfolge Nickel, Palladium und Gold aufweisen.

7. Optoelektronisches Halbleiterbauteil (1) nach einem der vorhergehenden Ansprüche,
bei dem die Federn (7) als Federstifte (11) gestaltet sind.

8. Optoelektronisches Halbleiterbauteil (1) nach einem der vorhergehenden Ansprüche,
das einen Gehäusekörper (18) umfasst, so dass Anschlussträger (4) und Gehäusekörper (18) einen Hohlraum (19) einschließen, in dem sich der Halbleiterchip (2) befindet.

9. Optoelektronisches Halbleiterbauteil (1) nach einem der vorhergehenden Ansprüche,
bei dem die elektrisch isolierende Schicht (9) durch einen Lack, einen Kunststoff oder ein Silikon gebildet ist.

10. Optoelektronisches Halbleiterbauteil (1) nach einem der vorhergehenden Ansprüche,
das mindestens zwei Anschlussträger (4) umfasst, und bei dem die elektrisch isolierende Schicht (9) die Anschlussträger (4) mechanisch miteinander verbindet.

11. Gerät (17) zur Aufzeichnung von Bildinformation, das mindestens ein optoelektronisches Halbleiterbauteil (1) nach einem der vorhergehenden Ansprüche sowie mindestens eine Öffnung (16) zur Aufnahme des Halbleiterbauteils (1) umfasst, wobei das Halbleiterbauteil (1) durch Anpressen über die Federn (7) mit dem Gerät (17) elektrisch kontaktiert ist.

12. Verfahren zur Herstellung eines optoelektronischen Halbleiterbauteils (1) mit den Schritten:
- Bereitstellen mindestens eines Anschlussträgers (4),
- mindestens stellenweises Aufbringen einer elektrisch isolierenden Beschichtung (9) auf dem Anschlussträger (4),
- Aufbringen mindestens einer ersten Metallisierungsschicht (14) an einer Vorderseite (5) und einer zweiten Metallisierungsschicht (15) auf einer Rückseite (6) des Anschlussträgers (4), wobei die von der elektrisch isolierenden Schicht (9) unbedeckten Bereiche des Anschlussträgers (4) beschichtet werden,
- Anbringen von mindestens zwei Federn (7) an einer Rückseite (6) des Anschlussträgers (4), und
- Anbringen mindestens eines optoelektronischen Halbleiterchips (2) an einer Vorderseite (5) des Anschlussträgers (4),
wobei die erste Metallisierungsschicht (14) eine mindestens um einen Faktor 2 größere Dicke aufweist als die zweite Metallisierungsschicht (15) und ein Dickenverhältnis der Metallisierungsschichten (14, 15) über den Beschichtungsgrad des Anschlussträgers (4) mit der elektrisch isolierenden Schicht (9) eingestellt ist.

13. Verfahren nach Anspruch 12,
wobei die Metallisierungsschichten (14, 15) über ein elektrogalvanisches Verfahren aufgebracht werden.

14. Verfahren nach Anspruch 12 oder 13,
wobei das Verhältnis der Schichtdicke der ersten Metallisierungsschicht (14) zur Schichtdicke der zweiten Metallisierungsschicht (15) mittels des Bedeckungsgrads der Vorderseite (5) mit der elektrisch isolierenden Schicht (9) bestimmt wird, und
wobei sich die elektrisch isolierende Schicht (9) auf die Vorderseite (5) des Anschlussträgers (4) beschränkt.

15. Verfahren nach einem der Ansprüche 12 bis 14,
wobei die erste Metallisierungsschicht (14) mit einer obersten Schicht (28) aus Gold versehen wird, und wobei die elektrische Kontaktierung des Halbleiterchips (2) mit der obersten Goldschicht über Bonden mit einem Bonddraht (13) erfolgt.
